Europäisches Patentamt

European Patent Office

Office européen des brevets

(11) Publication number: **0 098 177**
**B1**

(12) EUROPEAN PATENT SPECIFICATION

(45) Date of publication of patent specification: **22.03.89**

(51) Int. Cl.⁴: **H 01 J 37/302, H 01 J 37/317**

(21) Application number: **83303812.8**

(22) Date of filing: **30.06.83**

(54) Scanning electron-beam exposure system.

(30) Priority: **30.06.82 JP 111534/82**

(43) Date of publication of application:
**11.01.84 Bulletin 84/02**

(45) Publication of the grant of the patent:
**22.03.89 Bulletin 89/12**

(84) Designated Contracting States:
**DE FR GB**

(56) References cited:
**EP-A-0 002 957**
**EP-A-0 053 225**
**FR-A-2 375 665**

(73) Proprietor: **FUJITSU LIMITED**
**1015, Kamikodanaka Nakahara-ku**
**Kawasaki-shi Kanagawa 211 (JP)**

(72) Inventor: **Kawashima, Kenichi**
**24-26-102, Asahi-cho Sagami-hara-shi**
**Kanagawa 228 (JP)**
Inventor: **Osada, Toshihiko**
**600-5-14-203, Kashiwagaya Ebina-shi**
**Kanagawa 243 (JP)**
Inventor: **Nakagawa, Kenji**
**3-9-5, Takamoridai Isehara-shi**
**Kanagawa 259-11 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a scanning electron-beam exposure system.

In recent years, in semiconductor manufacturing technology, lithography carried out by means of electron beams instead of by means of light has been made possible. Electron-beam lithography is suitable for manufacturing a fine structure. Particularly, in a scanning-type electron-beam exposure system, a pattern is formed directly by using design data. For example, a pattern on a wafer can be exposed without using a mask, and, therefore, the step of manufacturing such a mask is unnecessary. In addition, the number of errors or defects in a pattern is reduced and the flexibility of a pattern is high. Electron-beam lithography can also be applied to the manufacture of a reticle or a photomask.

Furthermore, in a scanning-type electron-beam exposure system, in order to improve the throughput, rectangular beam exposure is used, as is a variable rectangular-beam exposure system in which the shape of a beam is variable in view of the flexibility of generating patterns.

In the above-mentioned variable rectangular-beam exposure system, even if the shape of a beam is changed, the size thereof has a maximum limit. If this maximum limit is defined as a maximum rectangle, there is no problem in a case where a depicted rectangular pattern is smaller than the maximum rectangle. However, in a case where a depicted rectangular pattern is larger than the maximum rectangle, a plurality of exposure-scanning operations are necessary. In the prior art, when such a large rectangular pattern is depicted, the pattern is divided into a plurality of maximum rectangles exposed by a predetermined exposure dose. Thus, such depicted maximum rectangles are combined into a pattern.

In the above-mentioned prior art, however, there is a problem in that the border of each exposed pattern deviates. Such a deviation is due to various factors. One factor is that heat generated by electron-beam exposure accumulates in a resist so that the sensibility of the resist become high. Another factor is the problem of beam alignment, or the lifetime of a gum filament. Particularly, the deviation of a border causes harmful effects in the formation of resistance patterns of an analog integrated circuit in a photomask or a wafer.

It is thus desirable to provide a scanning electron-beam exposure system in which the problem of deviation of the borders of exposed patterns is overcome.

EP—A1—0 053 225 discloses an electron beam system and method for writing patterns, such as on semiconductor wafers, in which a writing field is divided into a large number of subfields which are exposed sequentially. Each subfield is divided into a series of rectangles, and defining data on each rectangle is stored in a pattern buffer. A rectangle generator converts data from the pattern buffer into control signals relative to spot shape, spot position, and exposure time of the electron beam.

According to the present invention, there is provided a scanning electron-beam exposure system for exposing by an electron beam a desired rectangular area, said desired area being larger than a predetermined rectangular area, comprising:

means for generating coordinate information and size information of said desired area relative to a pair of orthogonal axes in the plane of said desired area;

area-dividing means for dividing said desired area into a plurality of rectangular areas to be exposed, each smaller than or equal to said predetermined rectangular area; and

exposing means for exposing said rectangular areas by said electron beam so as to expose said desired area;

characterised in that said area-dividing means comprise:

a first area-dividing means for dividing said desired area into a first group of rectangular areas to sequentially generate coordinate information and size information, relative to the said orthogonal axes, of each of said first group of rectangular areas; and

a second area-dividing means for dividing said desired area into a second group of rectangular areas to sequentially generate coordinate information and size information, relative to the said orthogonal axes, of each of said second group of rectangular areas;

said first and second groups of rectangular areas being so chosen, and the members of one group being so shifted relative to those of the other group with respect to the said orthogonal axes, that no boundary between members of said second group of rectangular areas coincides with a boundary between members of said first group; and in that said exposing means is operable to expose said desired area dependent upon said coordinate and size information of each of said first and second groups of rectangular areas, by exposing said first and second groups of rectangular areas respectively with an electron beam dose which is less than a predetermined electron beam dose.

In an embodiment of the present invention, there are prepared two kinds of divided areas two-dimensionally shifted from each other. First, one kind of divided areas are exposed by half of a predetermined electron-beam exposure dose and then the other kind of divided areas are exposed by half of the predetermined electron-beam exposure dose. Since the two different kinds of areas are superposed on each other, deviation of the border of each area is no longer troublesome.

The present invention will be more clearly understood from the description as set forth below with reference to the accompanying drawings, by way of example only, wherein:

Figs. 1A and 1B are diagrams of a rectangular area divided into a plurality of areas in accordance with the present invention;

Fig. 2 is a block diagram illustrating an embodiment of the scanning electron-beam exposure system according to the present invention;

Fig. 3 is a circuit diagram of the pattern generator 203A of Fig. 2; and

Fig. 4 is a circuit diagram of the pattern generator 203B of Fig. 2.

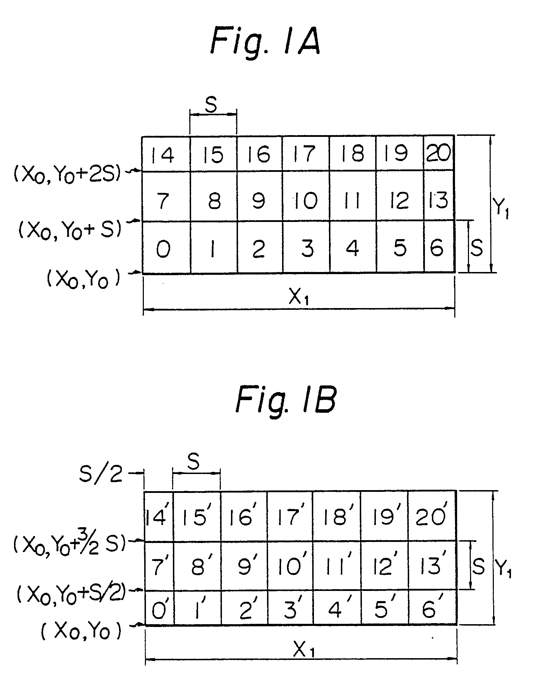

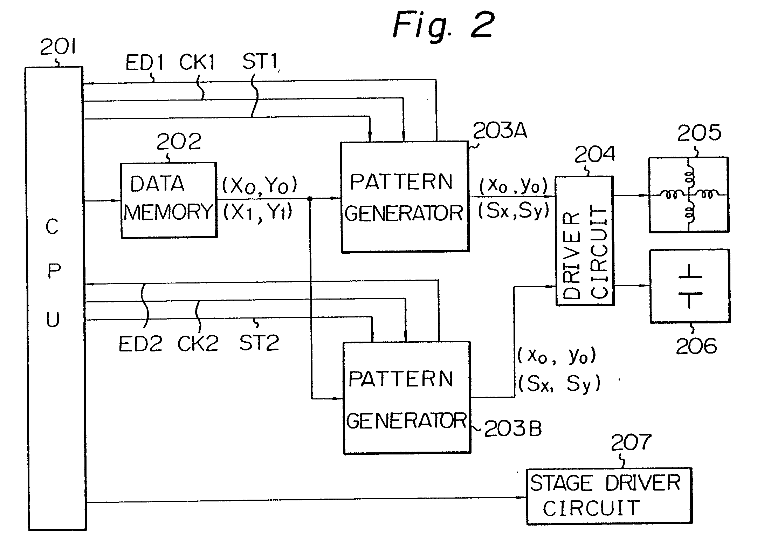

A rectangular pattern stored in a data memory (shown in Fig. 2 but not in Fig. 1) is determined by terminal coordinate information $(X_0, Y_0)$ and size $(X_1, Y_1)$. Here, if the maximum rectangle of an electron beam is defined as $S \times S$, as is illustrated in Fig. 1A, the, rectangular pattern is divided into patterns 0 thorugh 6 arranged in the X direction of the coordinates $(X_0, Y_0)$, patterns 7 through 13 arranged in the X direction of the coordinates $(X_0, Y_0+S)$, and patterns 14 through 20 arranged in the X direction of the coordinates $(X_0, Y_0+2S)$. In this case, the patterns 6 and 13 to 20 inclusive are smaller than the maximum rectangle, and the other patterns are the same as the maximum rectangle. On the other hand, as is illustrated in Fig. 1B, the rectangular pattern is divided into patterns 0' thorugh 6' arranged in the X direction of the coordinates $(X_0, Y_0)$, patterns 7' through 13' arranged in the X direction of the coordinates $(X_0, Y_0+S/2)$, and patterns 14' through 20' arranged in the X direction of the coordinates $(X_0, Y_0+3S/2)$. In this case, the patterns 0' to 7' inclusive and 14' are smaller than the maximum rectangle, and the other patterns are the same as the maximum rectangle. That is, the divided patterns illustrated in Fig. 1B are shifted by S/2 in the X direction and by S/2 in the Y direction as compared with the divided patterns illustrated in Fig. 1A.

In an embodiment of the invention, such two kinds of divided patterns are prepared. First, the patterns 0 through 20, respectively, of Fig. 1A are exposed by half of a predetermined electron-beam dose. Next, the patterns 0' through 20', respectively, of Fig. 1B are exposed by half of the predetermined electron-beam dose. That is, an exposure operation is performed so as to superpose the exposed patterns of Fig. 1A on the exposed patterns of Fig. 1B. As a result, deviation of the border of each of the patterns 0 thorugh 20 and the patterns 0' through 20' is prevented.

In Fig. 2, which illustrates an embodiment of the present invention, reference numeral 201 indicates a central processing unit (CPU), and reference numeral 202 indicates a data memory for storing rectangular patterns such as the rectangular pattern illustrated in Fig. 1A or Fig. 1B. That is, in this case, the data memory 202 stores terminal coordinate information $(X_0, Y_0)$ and size information $(X_1, Y_1)$. Reference numerals 203A and 203B indicate pattern generators. For example, the pattern generator 203A generates terminal coordinate information $(x_0, y_0)$ and size information $(S_X, S_Y)$ as parameters corresponding to each divided pattern illustrated in Fig. 1A to a driver circuit 204. Similarly, the pattern generator 203B generates parameters $x_0, y_0, S_X,$ and $S_Y$ corresponding to each divided pattern illustrated in Fig. 1B to the driver circuit 204. The driver circuit 204 drives a main deflection lens 205 and a slit deflection lens 206 to determine the beam positions $x_0$ and $y_0$ and the beam size $S_X$ and $S_Y$. A stage-driver control circuit 207 is used for moving a stage of the electron-beam exposure system.

The operation of the pattern generator 203A is initiated by a start signal ST1 of the CPU 201 and proceeds with the pulses of a system clock signal CK1. When exposure of the divided patterns illustrated in Fig. 1A is completed, the pattern generator 203A generates an exposure end signal ED1 which is transmtited to the CPU 201. Next, the CPU 201 generates a start signal ST2 to initiate operation of the pattern generator 203B which proceeds with the pulses of a system clock signal CK2. When exposure of the divided patterns illustrated in Fig. 1B is completed, the pattern generator 203B generates an exposure end signal ED2 which is trransmitted to the CPU 201. As a result, exposure of the rectangular patterns illustrated in Figs. 1A and 1B is completed. Therefore, the CPU 201 proceeds to expose the next rectangular pattern stored in the data memory 202.

The pattern generators 203A and 203B of Fig. 2 are now explained in more detail.

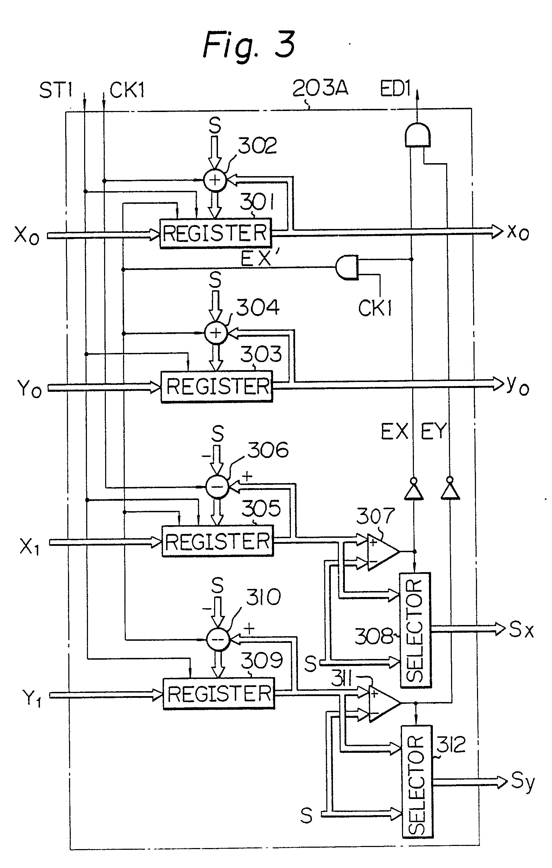

In Fig. 3, which illustrates the pattern generator 203A of Fig. 2, a register 301 and an adder 302 are provided in order to generate X-direction coordinate information $x_0$ of a terminal point of a divided pattern, and a register 303 and an adder 304 are provided in order to generate Y-direction coordinate information $y_0$ of a terminal point of a divided pattern. In addition, a register 305, a subtracter 306, a comparator 307, and a selector 308 are provided in order to generate size information $S_x$ in the X-direction of a divided pattern, and a register 309, a subtractor 310, a comparator 311, and a selector 312 are provided in order to generate size information $S_y$ in the Y-direction of a divided pattern.

The operation of the circuit of Fig. 3 is explained with reference to Fig. 1A. First, the CPU 201 generates a start signal ST1, and parameters $X_0, Y_0, X_1$ and $Y_1$, are supplied from the data memory 202 to the registers 301, 303, 305, and 309, respectively. Here, the comparator 307 compares $X_1$ with the maximum size S. As a result, since $X_1 > S$, the selector 308 selects the lower input S thereof and, accordingly, $S_x=S$. In addition, the comparator 311 compares $Y_1$ with the maximum size S. As a result, since $Y_1 > S$, the selector 312 selects the lower input S thereof and, accordingly, $S_Y=S$. That is, pattern O of the parameters $(x_0, y_0, S_X, S_Y)$ in $(X_0, Y_0, S, S)$.

Next, after the driver circuit 204 exposes the pattern O with a predetermined dose, the CPU 201 generates a pulse of the system clock signal CK1. As a result, the pattern generator 203A performs an operation for generating the pattern 1 of the parameters shown in Fig. 1A. That is, the value of the register 301 is changed by the adder 302 from $X_0$ to $X_0+S$. In addition, the value of the register 305 is changed by the subtractor 306 from $X_1$ to $X_1-S$. In this case, the output of the comparators 307 and 311 remain unchanged. Therefore,

$$S_x = S$$

$$S_y = S.$$

That is, the pattern 1 of the parameters $(x_0, y_0, S_x, S_y)$ is

$$(X_0 + S, Y_0, S, S).$$

Similarly, the pattern generator 203A performs, an operation for generating the pattern 6 of the parameters $(x_0, y_0, S_x, S_y)$ shown in Fig. 1A so that the pattern 6 of the parameters is

$$(X_0 + 6S, Y_0, X_1 - 6S, S).$$

In this case, $X_1 - 6S < S$. Therefore, the output of the comparator 307 changes so that the selector 308 selects the upper input thereof and the X-direction scanning and signal EX becomes logic "1". In this state, when the next pulse of the system clock signal CK1 is generated, a signal EX' becomes logic "1" so that $X_0$ is again stored in the register 301 and the value of the register 303 is changed from $Y_0$ to $Y_0 + S$. In addition, $X_1$ is again stored in the register 305 and the value of the register 309 is changed from $Y_1$ to $Y_1 - S$. In this case, since $X_1 - S < S$ and $Y_1 - S < S$, the selectors 308 and 312 select the lower inputs thereof. Therefore, the pattern 7 of the parameters $(x_0, y_0, S_x, S_y)$ is

$$(X_0, Y_0 + S, S, S).$$

Finally, the pattern generator 203A performs an operation for generating the pattern 20 of the parameters $(x_0, y_0, S_x, S_y)$ shown in Fig. 1A so that the pattern 20 of the parameters is

$$(X_0 + 6S, Y_0 + 2S, X_1 - 6S, Y_1 - 2S).$$

In this case, $X_1 - 6S < S$ and $Y_1 - 2S < S$. Therefore, the outputs of the comparators 307 and 311 are both logic "1". As a result, an end signal EDI is transmitted to the CPU 201, thereby completing the exposure operation.

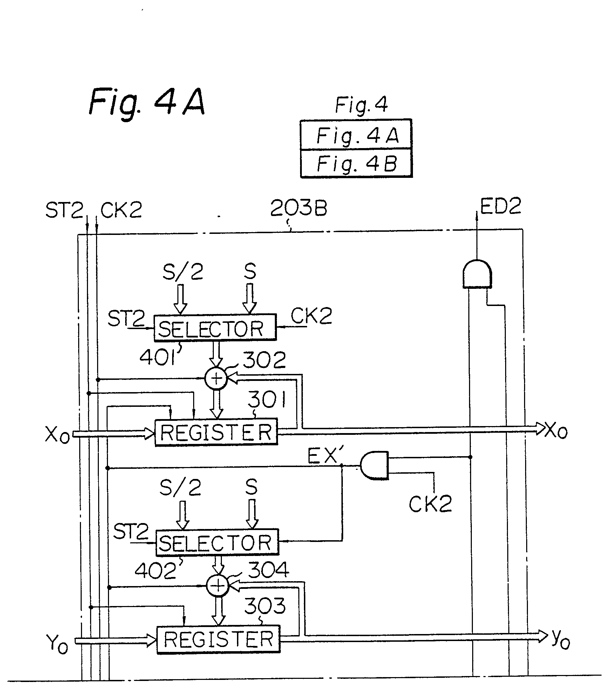

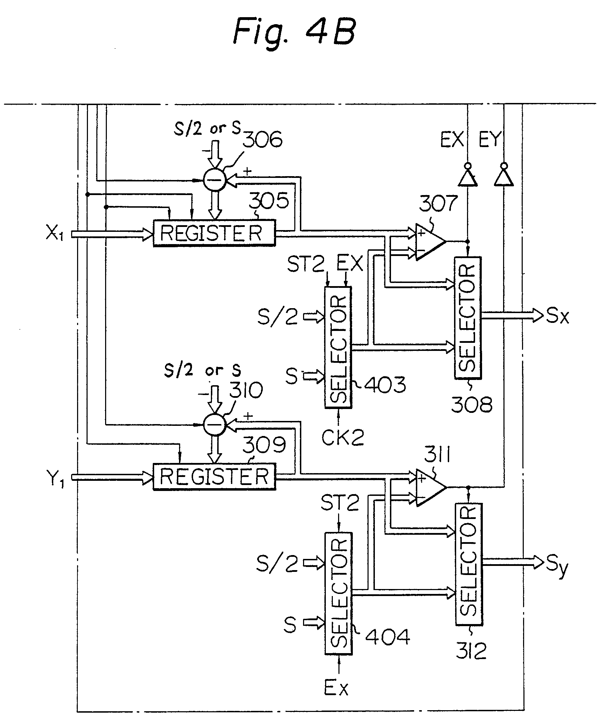

In Fig. 4, which illustrates the pattern generator 203B of Fig. 2, selectors 401 through 404 are added to the elements of Fig. 3. That is, the selectors 401 and 402 are provided so that the first change amount of each of the parameters $x_0$ and $y_0$ is set as S/2, not as S, and the selectors 403 and 404 are provided such that the first comparison reference value of each of the comparators 307 and 311 is set as S/2, not as S.

The operation of the circuit of Fig. 4 is explained with reference to Fig. 1B. First, the CPU 201 generates a start signal ST2, and parameters $X_0$, $Y_0$, $X_1$, and $Y_1$ are supplied from the data memory 202 to the registers 301, 303, 305 and 309, respectively. Simultaneously, the selectors 401 through 404 select S/2. Therefore, the comparator 307 compares $X_1$ with S/2. As a result, since $X_1 > S/2$, the selector 308 selects the lower input S/2 thereof and, accordingly, $S_x = S/2$.

In addition, the comparator 311 compares $Y_1$ with S/2. As a result, since $Y_1 > S/2$, the selector 312 selects the lower input S/2 thereof and, accordingly, $S_y = S/2$. That is, the pattern 0' of the parameters $(x_0, y_0, S_x, S_y)$ is $(X_0, Y_0, S/2, S/2)$.

Next, after the driver circuit 204 exposes the pattern 0' with a predetermined electron-beam dose, the CPU 201 generates a pulse of the system clock CK2 applied as a control signal to selectors 401, 403 and adders 302, 306. As a result, the pattern generator 203B performs an operation for generating the pattern 1' of the parameters shown in Fig. 1B. That is, the value of the register 301 is changed by the adder 302 from $X_0$ to $X_0 + S/2$. In addition, the value of the register 305 is changed by the subtractor 306 from $X_1$ to $X_1 - S/2$. That is, subtractor 306 is supplied with S/2 instead of S by not-shown selector means. In this case, the outputs of comparators 307 and 311 remain unchanged. However, the selector 403 selects the value S (due to CK2). Therefore,

$$S_x = S$$

$$S_y = S/2.$$

That is, the pattern 1' of the parameters $(x_0, y_0, S_x, S_y)$ is

$$(X_0 + S/2, Y_0, S, S/2).$$

Thus, the pattern generator 203B performs an operation for generating the pattern 6' of the parameters $(x_0, y_0, S_x, S_y)$ shown in Fig. 1B so that the pattern 6' of the parameters is

$$(X_0 + 11S/2, Y_0, X_1 - 11S/2, S/2).$$

In this case, $X_1 - 11S/2 < S$. Therefore, the output of the comparator 307 changes so that the selector 308 selects the upper input thereof and the X-direction scanning end signal EX becomes logic "1" and is applied as a control signal to the selectors 403, 404. In this state, when the next pulse of the system clock signal CK2 is generated, a signal EX' become logic "1" and is applied as a control signal to the registers 301, 305 and adders 304, 310 so that $X_0$ is again stored in the register 301 and the value of the register 303 is changed from $Y_0$ to $Y_0 + S/2$. In addition, $X_1$ is again stored in the register 305 and the value of the register 309 is changed from $Y_1$ to $Y_1 - S/2$. That is, subtractor 310 is supplied with S/2 instead of S by not-shown selector means. In this case, since $X_1 - S > S$ and $Y_1 - S/2 > S$, the selectors 308 and 312 select the inner inputs S/2 or S thereof now supplied from selectors 403, 404 respectively. Therefore, the pattern 7' of the parameters $(x_0, y_0, S_x, S_y)$ is

$$(X_0, Y_0 + S/2, S/2, S).$$

Finally, the pattern generator 203B performs an operation for generating the pattern 20' of

the parameters $(x_0, y_0, S_x, S_y)$ shown in Fig. 1B so that the pattern 20' of the parameters is

$$(X_0+11S/2, Y_0+3S/2, X_1-11S/2, Y_1-3S/2).$$

In this case, $X_1-11S/2 < S$ and $Y_1-3S/2 < S$. Therefore, the outputs of the comparators 307 and 311 are both logic "1". As a result, an end signal ED2 is transmitted to the CPU 201, thereby completing the exposure operation.

In the above-mentioned embodiment, the shift quantities in the X- and Y-directions between the two kinds of divided patterns are both S/2. However, it should be noted that such shift quantities can be other values only when both the X-direction and the Y-direction are shifted.

As was explained above, in an embodiment of the present invention, deviation of the border of patterns can be protected against.

## Claims

1. A scanning electron-beam exposure system for exposing by an electron beam a desired rectangular area, said desired area being larger than a predetermined rectangular area, comprising:

means (202) for generating coordinate information $(X_0, Y_0)$ and size information $(X_1, Y_1)$ of said desired area relative to a pair of orthogonal axes in the plane of said desired area;

area-dividing means (203A, 203B) for dividing said desired area into a plurality of rectangular areas to be exposed, each smaller than or equal to said predetermined rectangular area $(S \times S)$; and

exposing means (204, 205, 206) for exposing said rectangular areas by said electron beam so as to expose said desired area;

characterised in that said area-dividing means (203A, 203B) comprise:

a first area-dividing means (203A) for dividing said desired area into a first group of rectangular areas (0...20) to sequentially generate coordinate information $(x_0, y_0)$ and size information $(S_x, S_y)$, relative to the said orthogonal axes, of each of said first group of rectangular areas; and

a second area-dividing means (203B) for dividing said desired area into a second group of rectangular areas (0'...20') to sequentially generate coordinate information $(x_0, y_0)$ and size information $(S_x, S_y)$, relative to the said orthogonal axes, of each of said second group of rectangular areas;

said first and second groups of rectangular areas being so chosen, and the members of one group being so shifted relative to those of the other group with respect to the said orthogonal axes, that no boundary between members of said second group of rectangular areas coincides with a boundary between members of said first group; and in that

said exposing means (204, 205, 206) is operable to expose said desired area dependent upon said coordinate and size information of each of said first and second groups of rectangular areas, by exposing said first and second groups of rectangular areas respectively with an electron beam dose which is less than a predetermined electron beam dose.

2. A system as claimed in claim 1, wherein said exposing means exposes said first group of rectangular areas with half of the said predetermined electron-beam dose and exposes said second group of rectangular areas with half of the said predetermined electron-beam dose.

3. A system as claimed in claim 1 or 2, wherein said means (202) for generating coordinate and size information of said desired area comprises a data memory.

4. A system as claimed in claim 1, 2 or 3, further comprising a central processing unit (201) operable to control said first and second area-dividing means (203A, 203B) and said means (202) for generating coordinate and size information of said desired area.

5. A system as claimed in any preceding claim, wherein said exposing means comprises at least one deflection lens (205, 206) for said electron beam, and a driver circuit (204) for driving said at least one deflection lens under control of said first or second area-dividing means (203A, 203B).

## Patentansprüche

1. Abtastelektronenstrahl-Belichtungssystem zum Belichten eines gewünschten rechtwinkligen Bereiches durch einen Elektronenstrahl, welcher gewünschte Bereich größer als ein vorbestimmter rechtwinkliger Bereich ist, mit:

Einrichtungen (202) zum Erzeugen von Koordinateninformation $(X_0, Y_0)$, und Größeninformation $(X_1, Y_1)$ des genannten gewünschten Bereichs relativ zu einem Paar von orthogonalen Achsen in der Ebene des genannten gewünschten Bereiches;

Bereichsteilungseinrichtungen (203A, 203B), zum Teilen des gewünschten Bereiches in eine Vielzahl von rechtwinkligen Bereichen, die zu belichten sind, jeweils kleiner oder gleich dem genannten vorbestimmten rechtwinkligen Bereich $(S \times S)$; und

Belichtungseinrichtungen (204, 205, 206) zum Belichten des genannten rechtwinkligen Bereiches durch den genannten Elektronenstrahl, um so den genannten gewünschten Bereich zu belichten;

dadurch gekennzeichnet, daß die genannte Bereichsteilungseinrichtung (203A, 203B) umfaßt:

eine erste Bereichsteilungseinrichtung (203A) zum Teilen des gewünschten Bereiches in eine erste Gruppe von rechtwinkligen Bereichen (0...20), um sequentiell Koordinateninforamtion $(x_0, y_0)$ und Größeninformation $(S_x, S_y)$ zu erzeugen, relativ zu den genannten orthogonalen Achsen, von jeder ersten Gruppe von rechtwinkligen Dreiecken und

eine zweite Bereichsteilungseinrichtung (203B), zum Teilen des gewünschten Bereiches in eine zweite Gruppe von rechtwinkligen Bereichen (0'...20'), um sequentiell Koordinateninformation ($x_0$, $y_0$) und Größeninformation ($S_x$, $S_y$), relativ zu den orthogonalen Achsen, von jeder genannten zweiten Gruppe von rechtwinkligen Bereichen zu erzeugen;

wobei die ersten und zweiten Gruppen von rechtwinkligen Bereichen so gewählt sind, und die Teile von einer Gruppe so relativ zu jenen von der anderen Gruppe in Bezug auf die genannten orthogonalen Achsen verschoben werden, daß keine Grenze zwischen Teilen der genannten zweiten Gruppe von rechtwinkligen Bereichen mit einer Grenze zwischen Teilen der genannten ersten Gruppe koinzidiert; und daß

die genannte Belichtungseinrichtung (204, 205, 206) betreibbar ist, um den gewünschten Bereich zu belichten, abhängig von der genannten Koordinaten- und Größeninformation von jeder der ersten und zweiten Gruppen von rechtwinkligen Bereichen, durch Belichten der genannten ersten bzw. zweiten Gruppen von rechtwinkligen Bereichen mit einer Elektronenstrahldosis, die kleiner als eine vorbestimmte Elektronenstrahldosis sein kann.

2. System nach Anspruch 1, bei dem die genannte Belichtungseinrichtung die genannte erste Gruppe von rechtwinkligen Bereichen mit der Hälfte der genannten vorbestimmten Elektronenstrahldosis belichtet und die genannte zweite Gruppe von rechtwinkligen Bereichen mit der Hälfte der genannten vorbestimmten Elektronenstrahldosis belichtet.

3. System nach Anspruch 1 oder 2, bei dem die genannte Einrichtung (202) zur Erzeugung von Koordinaten- und Größeninformation des genannten gewünschten Bereiches einen Datenspeicher umfaßt.

4. System nach Anspruch 1, 2 oder 3, ferner mit einer zentralen Prozessoreinheit (201), die betriebbar ist, um die genannten ersten und zweiten Bereichsteilungseinrichtungen (203A, 203B) und die genannte Einrichtung (202) zur Erzeugung von Koordinaten- und Größeninformation von dem genannten gewünschten Bereich zu steuern.

5. System nach einem der vorhergehenden Ansprüche, bei dem die genannte Belichtungseinrichtung wenigstens eine Ablenklinse (205, 206) für den genannten Elektronenstrahl und eine Treiberschaltung (204) zum Treiben der genannten wenigstens einen Ablenklinse unter der Steuerung der genannten ersten oder zweiten Bereichsteilungseinrichtung (203A, 203B) umfaßt.

**Revendications**

1. Un système d'exposition par faisceau d'électrons à balayage destiné à exposer une zone rectangulaire désirée au moyen d'un faisceau d'électrons, cette zone désirée étant plus grande qu'une zone rectangulaire prédéterminée, comprenant:

des moyens (202) pour produire une information de coordonnées ($X_0$, $Y_0$) et une information de taille ($X_1$, $Y_1$) de la zone désirée, par rapport à une paire d'axes orthogonaux dans le plan de la zone désirée;

des moyens de division de zone (203A, 203B) destinés à diviser la zone désirée en un ensemble de zones rectangulaires à exposer, chacune d'elles ayant des dimensions inférieures ou égales à celles de la zone rectangulaire prédéterminée ($S \times S$); et

des moyens d'exposition (204, 205, 206) pour exposer les zones rectangulaires au moyen du faisceau d'électrons, afin d'exposer la zone désirée;

caractérisé en ce que les moyens de division de zone (203A, 203B) comprennent:

des premiers moyens de division de zone (203A) destinés à diviser la zone désirée en un premier groupe de zones rectangulaires (0,...20), pour produire séquentiellement une information de coordonnées ($x_0$, $y_0$) et une information de taille ($S_x$, $S_y$), par rapport aux axes orthogonaux, pour chaque zone du premier groupe de zones rectangulaires; et

des seconds moyens de division de zone (203B) pour diviser la zone désirée en un second groupe de zones rectangulaires (0',...20'), afin de produire séquentiellement une information de coordonnées ($x_0$, $y_0$) et une information de taille ($S_x$, $S_y$), par rapport aux axes orthogonaux pour chaque zone du second groupe de zones rectangulaires;

les premier et second groupes de zones rectangulaires étant choisis, et les membres d'un group étant décalés par rapport à ceux de l'autre groupe par rapport aux axes orthogonaux, de façon qu'aucune frontière entre des membres du second groupe de zones rectangulaires ne coïncide avec une frontière entre des membres du premier groupe; et en ce que

les moyens d'exposition (204, 205, 206) sont capables d'exposer la zone désirée sous la dépendance de l'information de coordonnées et de taille de chaque zone des premier et second groupes de zones rectangulaires, en exposant respectivement les premier et second groupes de zones rectangulaires avec une dose de faisceau d'électrons qui est inférieure à une dose de faisceau d'électrons prédéterminée.

2. Un système selon la revendication 1, dans lequel les moyens d'exposition exposent le premier groupe de zones rectangulaires avec la moitié de la dose de faisceau d'électrons prédéterminée, et ils exposent le second groupe de zones rectangulaires avec la moitié de la dose de faisceau d'électrons prédéterminée.

3. Un système selon la revendication 1 ou 2, dans lequel les moyens (202) destinés à produire une information de coordonnées et de taille de la zone désirée comprennent une mémoire de données.

4. Un système selon la revendication 1, 2 ou 3, comprenant en outre une unité centrale de traitement (201), capable de commander les premiers et seconds moyens de division de zone (203A, 203B) et les moyens (202) destinés à produire une information de coordonnées et de taille de la zone désirée.

5. Un système selon l'une quelconque des revendications précédentes, dans lequel les moyens d'exposition comprennent au moins une lentille déflectrice (205, 206) pour le faisceau d'électrons, et un circuit d'attaque (204) destiné à attaquer la ou les lentilles déflectrices sous la commande des premiers ou seconds moyens de division de zone (203A, 203B).

## Fig. IA

$$\begin{array}{|c|c|c|c|c|c|c|}
\hline
14 & 15 & 16 & 17 & 18 & 19 & 20 \\
\hline
7 & 8 & 9 & 10 & 11 & 12 & 13 \\
\hline
0 & 1 & 2 & 3 & 4 & 5 & 6 \\
\hline
\end{array}$$

$S$

$(X_0, Y_0 + 2S)$

$(X_0, Y_0 + S)$

$(X_0, Y_0)$

$Y_1$

$S$

$X_1$

## Fig. IB

$$\begin{array}{|c|c|c|c|c|c|c|}
\hline
14' & 15' & 16' & 17' & 18' & 19' & 20' \\
\hline
7' & 8' & 9' & 10' & 11' & 12' & 13' \\
\hline
0' & 1' & 2' & 3' & 4' & 5' & 6' \\
\hline
\end{array}$$

$S/2$

$S$

$(X_0, Y_0 + \frac{3}{2} S)$

$(X_0, Y_0 + S/2)$

$(X_0, Y_0)$

$S$ $Y_1$

$X_1$

# Fig. 2

# Fig. 3

# Fig. 4A

Fig. 4

| Fig. 4 A |
|----------|
| Fig. 4 B |

# Fig. 4B